# EUROPÄISCHE PATENTANMELDUNG

(11) **EP 0 817 278 A2**
(43) Veröffentlichungstag der Anmeldung: **07.01.1998**
(21) Anmeldenummer: 97109601.1
(22) Anmeldetag: 11.06.1997
(51) Int. Cl.: H01L 29/788, H01L 21/336, H01L 29/423

(54) **Speicherzelle**

(30) Priorität: 28.06.1996 DE 19626089
(71) Anmelder: SIEMENS AKTIENGESELLSCHAFT, 80333 München (DE)
(72) Erfinder: Kerber, Martin, 81827 München (DE)

(57) **Zusammenfassung**

Die Speicherzelle, auf deren halbleitenden Grundkörper (1) mehrere strukturierte Schichten angeordnet sind, und die mit Hilfe des Fowler-Nordheim Tunneleffekts programmiert werden kann, weist einen exakt definierten Überlappbereich von erstem dotierten Bereich (2) und Floating-Gate-Schicht (5) auf. Die Control-Gate-Schicht (7) ist annähernd überlappungsfrei über dem ersten dotierten Bereich (2) angeordnet.

## Beschreibung

Die Erfindung betrifft eine Speicherzelle, die folgende Merkmale aufweist:
- Einen halbleitenden Grundkörper,
- einen ersten dotierten Bereich ersten Leitungstyps auf einer ersten Hauptflache des Grundkörpers, wobei der erste dotierte Bereich mit einem Source-Anschluß verbunden ist,
- einen zweiten dotierten Bereich ersten Leitungstyps auf der ersten Hauptfläche des Grundkörpers, wobei der zweite dotierte Bereich mit einem Drain-Anschluß verbunden ist,
- eine auf der ersten Hauptfläche angeordnete und von einer Oxidschicht unterlegte Floating-Gate-Schicht, die das Gebiet zwischen dem ersten dotierten Bereich und dem zweiten dotierten Bereich überdeckt und mindestens einen der beiden dotierten Bereiche teilweise überdeckt,
- eine auf der Floating-Gate-Schicht angeordnete und von einem Dielektrikum unterlegte Control-Gate-Schicht, die mit einem Control-Gate-Anschluß verbunden ist,
sowie ein Verfahren zu deren Herstellung.

Eine solche Speicherzelle ist beispielsweise aus Meinke, Gundlach "Lehrbuch der Hochfrequenztechnik", Springer, 5. Auflage, 1992, Seite M 40 ff. bekannt. Bei derartigen Speicherzellen wird der Stromfluß zwischen den beiden dotierten Bereichen, die jeweils mit dem Gate- oder dem Source-Anschluß verbunden sind, maßgeblich durch eine in der Floating-Gate-Schicht befindliche Ladung beeinflußt.

Die Aufladung bzw. Entladung der Floating-Gate-Schicht kann beispielsweise unter Ausnutzung des Fowler Nordheim Tunneleffekts durch Fließen eines Tunnelstromes zwischen der Floating-Gate-Schicht und einem der beiden dotierten Bereiche erfolgen. Konventionen in der Literatur folgend, wird im folgenden der mit dem Drain-Anschluß verbundene erste dotierte Bereich, häufig auch als Drain-Gebiet bezeichnet, als der dotierte Bereich angenommen, von dem aus der Tunnelstrom auf das Floating-Gate einsetzt, was jedoch nicht ausschließt, daß auch zwischen der Floating-Gate-Schicht und dem mit dem Source-Anschluß verbundenen zweiten dotierten Bereich, anstelle des Drain-Gebietes, ein Tunnelstrom fließen kann.

Das Einsetzen eines Tunnelstromes zwischen Floating-Gate-Schicht und Drain-Gebiet erfordert, neben dem Anlegen einer genügend hohen Spannung zwischen Control-Gate-Anschluß und Drain-Anschluß, auch ein Überlappen der Floating-Gate-Schicht über das Drain-Gebiet. Hierbei hängt die Höhe der anzulegenden Spannung, die auch als Programmierspannung bezeichnet wird, sowie die benötigte Zeitdauer zum Auf- bzw. Entladen der Floating-Gate-Schicht von einem unteren Potential auf ein oberes Potential bzw. umgekehrt, die auch als Programmierzeit bezeichnet wird, empfindlich vom Überlappbereich ab.

Bei bisherigen Speicherzellen wird zumeist eine gemeinsame Strukturkante von Control-Gate-Schicht und Floating-Gate-Schicht, auch als Gatekante bezeichnet, über dem Drain-Gebiet vorgesehen, d.h. Control-Gate-Schicht und Floating-Gate-Schicht überdecken das Drain-Gebiet gleichermaßen. Während des Herstellungsprozesses dieser Speicherzellen kann deshalb auf der ersten Hauptfläche des Grundkörpers das Drain-Gebiet nur bis an die Gatekante in die erste Hauptfläche eindotiert werden, so daß noch kein Überlappbereich von Floating-Gate-Schicht und Drain-Gebiet besteht. Der Überlappbereich ergibt sich aus einer nachfolgenden thermischen Diffussion des Drain-Gebietes unter die Floating-Gate-Schicht, wobei dieser Überlappbereich unter anderem durch drei Umstände eingeengt wird:
1. Die Dotierung des Drain-Gebietes kann aus verschiedenen Gründen nicht bis an die Gatekante erfolgen, was bei der nachfolgenden Diffusion in einem kleineren Überlappbereich resultiert.
2. Im Zuge der bei der Herstellung nachfolgenden Oxidationen bildet sich an der Gatekante eine dickere Oxidschicht, ein sogenannter Birds Beak, wodurch die Tunnelstromdichte exponentiell reduziert wird.
3. Die Dotierstoffkonzentration nimmt in lateraler Richtung stark ab, so daß effizientes Tunneln der Ladungsträger nur an der Gatekante erfolgen kann.

Insgesamt können also kleine Prozeßschwankungen bei der Herstellung der bisher beschriebenen Speicherzellen zu einer großen Streuung der Programmierspannung und Programmierzeit führen, da der für die Tunnelung maßgebliche Bereich, des Überlappbereichs von Drain-Gebiet und Floating-Gate-Schicht, durch die Differenz der Länge des Birds Beak und der Länge des unter die Floating-Gate-Schicht diffundierten dotierten Bereichs gegeben ist, und nicht exakt definiert werden kann.

Die Erfindung hat das Ziel die eingangs genannte Speicherzelle so weiterzubilden, daß sich eine exakt definierte Programmierspannung oder Programmierzeit ergibt, sowie ein Verfahren zu deren Herstellung anzugeben. Dieses Ziel wird mit einer Speicherzelle nach der Erfindung erreicht, die neben den eingangs genannten Merkmalen folgende zusätzliche Merkmale aufweist:
- Die Control-Gate-Schicht ist über wenigstens einem der beiden dotierten Bereiche derart angeordnet, daß die den dotierten Bereich überlappende Teilfläche der Control-Gate-Schicht geringer ist, als die den dotierten Bereich überlappende Teilfläche der Floating-Gate-Schicht.
- Der Abstand zwischen einer ersten Strukturkante und einer zweiten Strukturkante der Control-Gate-Schicht ist geringer, als der Abstand zwischen einer ersten Strukturkante und einer zweiten Strukturkante der Floating-Gate-Schicht.

Bei einer Speicherzelle der beschriebenen Struktur ist es in einfacher Art und Weise möglich, den für die Tunnelung maßgeblichen Bereich, des Überlappbereichs von Drain-Gebiet und Floating-Gate-Schicht, exakt festzulegen und somit Programmierspannung und Programmierzeit exakt zu definieren. Der für die Tunnelung maßgebliche Bereich, des Überlappbereichs von Drain-Gebiet und Floating-Gate-Schicht, entspricht bei Speicherzellen der angegebenen Struktur dem Überlappbereich von Drain-Gebiet und Floating-Gate-Schicht.

Weiterbildungen der Erfindung sind Gegenstand der Unteransprüche.

Die beschriebene Struktur erlaubt es, während des Herstellungsverfahrens der Speicherzelle die Größe des Überlappbereiches von Floating-Gate-Schicht und Draingebiet entsprechend der Größe des Bereiches der Floating-Gate-Schicht zu wählen, der nicht von der Control-Gate-Schicht überlappt ist.

Unter der Annahme, daß die Ladungsträger aus dem ersten dotierten Bereich, also dem Drain-Gebiet, auf die Floating-Gate-Schicht tunneln, ist ein Überlappen der Floating-Gate-Schicht über den zweiten dotierten Bereich nicht erforderlich. Eine Weiterbildung der Erfindung sieht ein Überlappen der Floating-Gate-Schicht über den zweiten dotierten Bereich vor, wobei die Control-Gate-Schicht den zweiten dotierten Bereich weniger überlappt als die Floating-Gate-Schicht.

Eine Ausführungsform der Speicherzelle nach der Erfindung sieht vor, daß die beiden dotierten Bereiche ersten Leitungstyps n-leitend sind, während eine weitere Ausführungsform vorsieht, daß die beiden dotierten Bereiche p-leitend sind. Die Ausführung des halbleitenden Grundkörpers kann beispielsweise in Silizium erfolgen, was den Vorteil eines gut beherrschbaren Herstellungsverfahrens dieser Speicherzelle beinhaltet, wahrend eine beispielsweise Ausführung des halbleitenden Grundkörpers in Galliumarsenid eine höhere Integrationsdichte verspricht. Bei beiden Ausführungsformen kann die Floating-Gate-Schicht aus dem entsprechenden Halbleitermaterial, also Silizium oder Galliumarsenid, bestehen, während sie bei einem aus Silizium bestehenden halbleitenden Grundkörper auch aus Siliziumnitrid bestehen kann.

Als Werkstoffe für die Floating-Gate-Schicht sind weiterhin Metallnitride oder Metallsilicide denkbar.

Das Verfahren zur Herstellung einer Speicherzelle nach einer der oben genannten Ausführungen ist Gegenstand der Ansprüche 12, 13 oder 14.

Die Erfindung wird nachfolgend im Zusammenhang mit Ausführungsbeispielen anhand von Figuren näher erläutert. Es zeigen:
- Fig. 1: ein erstes Ausführungsbeispiel einer Speicherzelle nach der Erfindung im Querschnitt,
- Fig. 2: ein weiteres Ausführungsbeispiel einer Speicherzelle im Querschnitt,
- Fig. 3-7: Darstellung der Speicherzelle im Querschnitt, während verschiedener Verfahrensschritte.

In den nachfolgenden Figuren bezeichnen, sofern nicht anders angegeben, gleiche Bezugszeichen gleiche Teile mit gleicher Bedeutung.

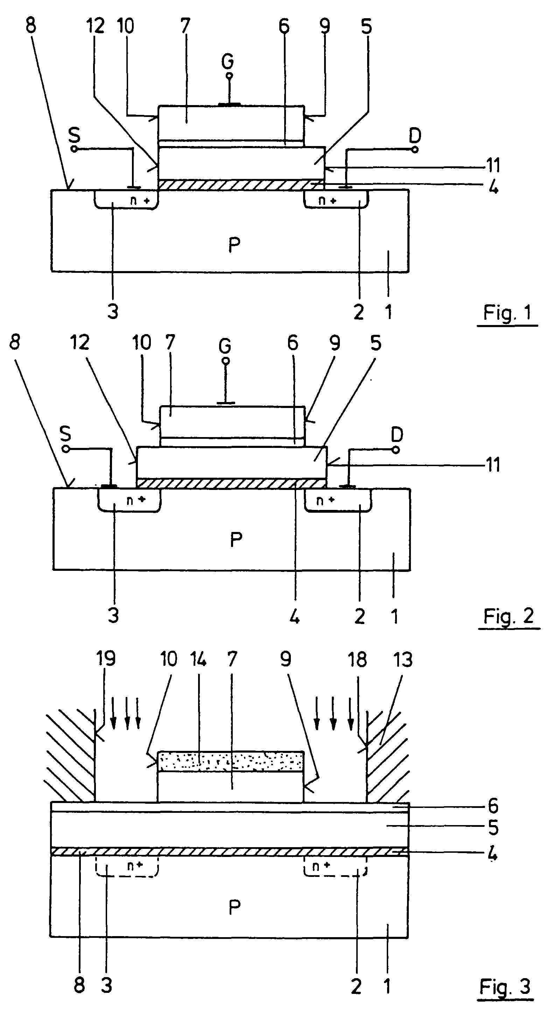

In Figur 1 ist ein erstes Ausführungsbeispiel einer Speicherzelle nach der Erfindung im Querschnitt dargestellt. In dem dargestellten Ausführungsbeispiel überlappt eine von einer Oxidschicht 4 unterlegte Floating-Gate-Schicht 5 einen ersten dotierten Bereich 2 teilweise. Der erste dotierte Bereich 2 ist in eine Hauptfläche 8 eines halbleitenden Grundkörpers 1 wannenförmig eindotiert. Der Überlappungsbereich von erstem dotierten Bereich 2 und Floating-Gate-Schicht 5 wird in Richtung eines zweiten wannenförmigen dotierten Bereiches 3 durch eine Ebene begrenzt, in der eine erste Strukturkante 9 einer Control-Gate-Schicht 7 enthalten ist. Die Control-Gate-Schicht 7 überlappt den ersten dotierten Bereich 2 somit nicht.

Sowohl Floating-Gate-Schicht 5 als auch die Control-Gate Schicht 7, die von der Floating-Gate-Schicht 5 durch ein Dielektrikum 6 getrennt ist, überlappen den zweiten dotierten Bereich 3 in dem dargestellten Beispiel nicht. Eine zweite Strukturkante 10 der Control-Gate-Schicht 7 und eine zweite Strukturkante 12 der Floating-Gate-Schicht 5 liegen hierbei in einer Ebene, welche, in Richtung des Halbleiterkörpers verlängert gedacht, den zweiten dotierten Bereich 3 begrenzt. In dem in Figur 1 dargestellten Beispiel sind die beiden dotierten Bereiche 2, 3 als n-dotiert angenommen, während der halbleitende Grundkörper 1 als p-dotiert angenommen ist. Es ist jedoch ebenso möglich, die beiden dotierten Bereiche 2, 3 p-leitend zu dotieren und den halbleitenden Grundkörper n-leitend zu dotieren.

Ebenso denkbar wäre es, den halbleitenden Grundkörper 1 und die beiden dotierten Bereiche 2, 3 als Bereiche gleichen Leitungstyps auszubilden, jedoch muß um die beiden dotierten Bereiche 2, 3 und zwischen den beiden dotierten Bereichen 2, 3 eine Wanne komplementären Leitungstyps vorgesehen werden.

In Figur 2 ist ein weiteres Beispiel einer Speicherzelle nach der Erfindung dargestellt. In dem dargestellten Ausführungsbeispiel werden sowohl der erste dotierte Bereich 2 als auch der zweite dotierte Bereich 3 von der Floating-Gate-Schicht 5 teilweise überlappt. Der erste dotierte Bereich 2 wird in Richtung des zweiten dotierten Bereichs 3 durch eine Ebene begrenzt, die die erste Strukturkante 9 der Control-Gate-Schicht 7 enthält. Der zweite dotierte Bereich 3 wird in diesem Ausführungsbeispiel in Richtung des ersten dotierten Bereiches 2 durch eine Ebene begrenzt, die eine zweite Strukturkante 10 der Control-Gate-Schicht 7 enthält.

Es ist anzumerken, daß die Control-Gate-Schicht 7 nicht notwendigerweise überlappungsfrei über einem der beiden oder beiden dotierten Bereichen 2, 3 angeordnet sein muß. Eine geringe Überlappung von Control-Gate-Schicht 7 und einem oder beiden der dotierten Bereiche 2, 3 ist üblicherweise unvermeidlich, da sich die dotierten Bereiche 2, 3 aufgrund thermischer Prozesse wahrend des Herstellverfahrens geringfügig ausbreiten.

Nachfolgend wird ein Ausführungsbeispiel zur Herstellung einer erfindungsgemäßen Speicherzelle anhand verschiedener Herstellschritte im Zusammenhang mit den Figuren 3 bis 7 erläutert.

In Figur 3 ist eine Speicherzelle während eines ersten Verfahrensschrittes des Herstellverfahrens nach der Erfindung dargestellt. In die erste Hauptfläche 8 des halbleitenden Grundkörpers 1, auf den bereits eine Oxidschicht 4, eine Floating-Gate-Schicht 5 und ein Dielektrikum 6 ganzflächig, sowie eine Control-Gate-Schicht 7 und eine Deckschicht 14 strukturiert aufgebracht sind, werden unter Verwendung einer Fotomaske 13 die beiden dotierten Bereiche 2, 3 eindotiert. Die Dotierung mittels Ionenimplantation erfolgt derart, daß der Dotierstoff durch die Floating-Gate-Schicht 5 auf die erste Hauptfläche 8 des Grundkörpers gelangt, wobei die Fotomaske 13 und die Control-Gate-Schicht 7 mit aufgebrachter Deckschicht 14 die Bereiche der Hauptfläche 8 schützen, in denen keine Dotierung erfolgen soll. Der erste dotierte Bereich 2 wird hierbei in Richtung des zweiten dotierten Bereiches 3 durch eine Ebene begrenzt, in der die erste Strukturkante 9 der Control-Gate-Schicht 7 enthalten ist. In entgegengesetzter Richtung wird der erste dotierte Bereich 2 durch eine Ebene begrenzt, in der eine erste Strukturkante 18 der Fotomaske 13 enthalten ist. Der zweite dotierte Bereich 3 wird in Richtung des ersten dotierten Bereiches 2 durch eine Ebene begrenzt, in der eine zweite Strukturkante 19 der Fotomaske 13 enthalten ist. In entgegengesetzter Richtung wird der zweite dotierte Bereich 3 durch eine Ebene begrenzt, in der die zweite Strukturkante 10 der Control-Gate-Schicht 7 enthalten ist. Anstelle der Strukturkanten 18 und 19, kann auch ein Feldoxid die dotierten Bereiche 2, 3 begrenzen.

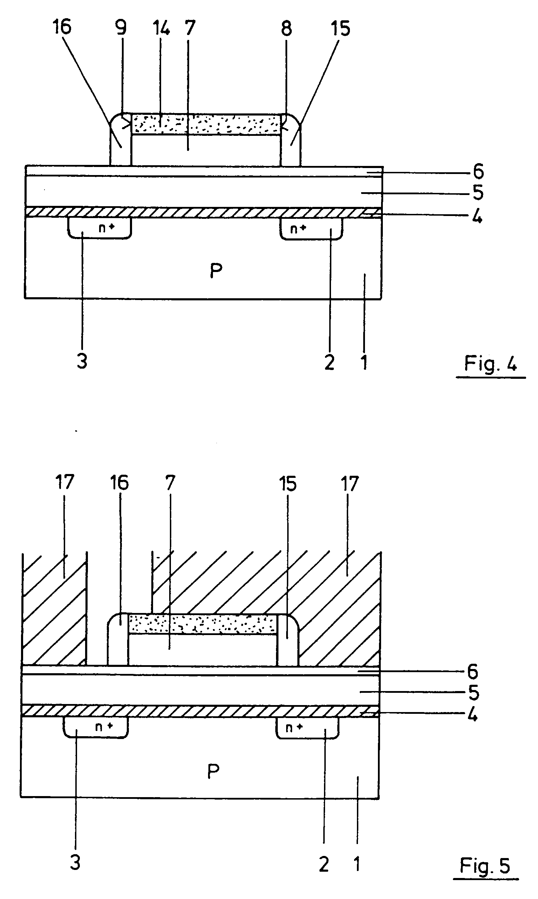

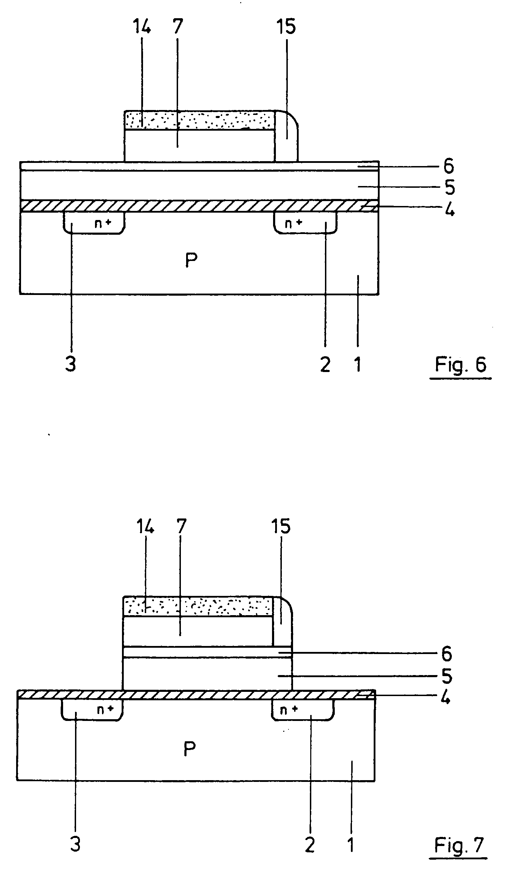

Nach Entfernen der Fotomaske 13 und Herstellen eines ersten Spacers 15 an der ersten Strukturkante 8 der Control-Gate-Schicht 7 und dem Herstellen eines zweiten Spacers 16 an der zweiten Strukturkante 9 der Control-Gate-Schicht 7, ergibt sich die in Figur 4 dargestellte Struktur. Die Herstellung der beiden Spacer 15, 16, kann beispielsweise durch isotropes Abscheiden und anisotropes Rückätzen erfolgen. In einem nächsten Verfahrensschritt kann unter Verwendung einer Fotomaske 17, wie in Figur 5 dargestellt, einer der beiden Spacer 15, 16, im dargestellten Fall der zweite Spacer 16, entfernt werden, so daß sich die in Figur 6 dargestellte Struktur für die Speicherzelle ergibt.

In einem weiteren Verfahrensschritt wird das Dielektrikum 6 beispielsweise durch anisotopes Ätzen in den Bereichen entfernt, in denen es nicht von Control-Gate-Schicht 7 und in dem vorliegenden Ausführungsbeispiel durch den Spacer 15 überdeckt ist. Dabei kann auch die Deckschicht 14 gedünnt, darf aber nicht vollständig entfernt werden. Nach Entfernen der Floating-Gate-Schicht 5 in den Bereichen, die nicht von Control-Gate-Schicht 7 und Spacer 15 überdeckt sind, ergibt sich die in Figur 7 dargestellte Struktur.

In einem weiteren Schritt des Herstellverfahrens der Speicherzelle nach der Erfindung werden die Deckschicht 14 von der Control-Gate-Schicht 7 sowie der Spacer 15 entfernt. Nachfolgend kann auf der Control-Gate-Schicht 7 die Metallisierung für den Control-Gate-Anschluß G sowie auf dem ersten dotierten Bereich 2 die Metallisierung für den Drain-Anschluß D und auf dem zweiten dotierten Bereich 3 die Metallisierung für den Source-Anschluß S erfolgen. Hierzu muß die Oxidschicht 4 ganz oder teilweise von den beiden dotierten Bereichen 2, 3 entfernt werden.

Während des Herstellverfahrens der in Figur 2 dargestellten "symmetrischen" Speicherzelle, entfällt das Entfernen eines der Spacer 15, 16 unter Verwendung einer Fotomaske 17 wie in Figur 5 dargestellt. Die anderen Verfahrensschritte verlaufen analog wie beschrieben.

## Patentansprüche

1. Speicherzelle mit einem Halbleiterkörper, die folgende Merkmale aufweist:
1.1. einen halbleitenden Grundkörper (1),
1.2. einen ersten dotierten Bereich (2) ersten Leitungstyps auf einer ersten Hauptfläche (8) des Grundkörpers (1), wobei der erste dotierte Bereich (2) mit einem Drain-Anschluß (D) verbunden ist,
1.3 einen zweiten dotierten Bereich (3) ersten Leitungstyps auf der Hauptfläche (8) des Grundkörpers (1), wobei der zweite dotierte Bereich (3) mit einem Source-Anschluß (S) verbunden ist,
1.4. eine auf der ersten Hauptfläche (8) angeordnete und von einer Oxidschicht (4) unterlegte Floating-Gate-Schicht (5), die das Gebiet zwischen dem ersten dotierten Bereich (2) und dem zweiten dotierten Bereich (3) überdeckt und mindestens einen der beiden dotierten Bereiche (2, 3) teilweise überdeckt,
1.5. eine auf der Floating-Gate-Schicht (5) angeordnete und von einem Dielektrikum (6) unterlegte Control-Gate-Schicht (7), die mit einem Control-Gate-Anschluß (G) verbunden ist,
**gekennzeichnet** durch die weiteren Merkmale:
1.6. die Control-Gate-Schicht (7) ist über wenigstens einem der beiden dotierten Bereiche (2, 3) derart angeordnet, daß die den dotierten Bereich (2, 3) überlappende Teilfläche der Control-Gate-Schicht (7) geringer ist, als die den dotierten Bereich überlappende Teilfläche der Floating-Gate-Schicht (5).
1.7. der Abstand zwischen einer ersten Strukturkante (9) und einer zweiten Strukturkante (10) der Control-Gate-Schicht (7) ist geringer als der Abstand zwischen einer ersten Strukturkante (11) und einer zweiten Strukturkante (12) der Floating-Gate-Schicht (7).

2. Speicherzelle nach Anspruch 1, dadurch gekennzeichnet, daß die Control-Gate-Schicht (7) über beiden dotierten Bereichen (2, 3) derart angeordnet ist, daß die die dotierten Bereiche (2, 3) überlappenden Teilflächen der Control-Gate-Schicht (7) geringer sind, als die die dotierten Bereiche (2, 3) überlappenden Teilflächen der Floating-Gate-Schicht (5).

3. Speicherzelle nach Anspruch 1, dadurch gekennzeichnet, daß die Control-Gate-Schicht (7) überlappungsfrei über wenigstens einem der beiden dotierten Bereiche (2, 3) angeordnet ist.

4. Speicherzelle nach Anspruch 1, dadurch gekennzeichnet, daß die Floating-Gate-Schicht (5) den ersten dotierten Bereich (2) und den zweiten dotierten Bereich (3) teilweise überlappt, während die Control-Gate-Schicht (7) überlappungsfrei über den beiden dotierten Bereichen (2, 3) angeordnet ist.

5. Speicherzelle nach einem der Ansprüche 1 bis 4, dadurch gekennzeichnet, daß die dotierten Bereiche (2, 3) ersten Leitungstyps n-leitend sind.

6. Speicherzelle nach einem der Ansprüche 1 bis 4, dadurch gekennzeichnet, daß die dotierten Bereiche (2, 3) ersten Leitungstyps p-leitend sind.

7. Speicherzelle nach einem der Ansprüche 1 bis 6, dadurch gekennzeichnet, daß der halbleitende Grundkörper (1) aus Silizium besteht.

8. Speicherzelle nach einem der Ansprüche 1 bis 6, dadurch gekennzeichnet, daß der halbleitende Grundkörper (1) aus Galliumarsenid besteht.

9. Speicherzelle nach einem der Ansprüche 1 bis 8, dadurch gekennzeichnet, daß die Floating-Gate-Schicht (5) aus Halbleitermaterial besteht.

10. Speicherzelle nach einem der Ansprüche 1 bis 6 und dem Anspruch 7, dadurch gekennzeichnet, daß die Floating-Gate-Schicht (5) aus Siliziumnitrid besteht.

11. Speicherzelle nach einem der Ansprüche 1 bis 8, dadurch gekennzeichnet, daß die Floating-Gate-Schicht (5) aus Metallnitrid oder aus Metallsilicid besteht.

12. Verfahren zur Herstellung einer Speicherzelle nach einem der Ansprüche 1 bis 11, gekennzeichnet durch folgende Verfahrensschritte:
12.1. In den halbleitenden Grundkörper (1), auf den bereits die Oxidschicht (4), die Floating-Gate-Schicht (5), das Dielektrikum (16), die Control-Gate-Schicht (7), sowie eine Deckschicht (14) der Control-Gate-Schicht (7) aufgebracht sind, werden unter Verwendung einer Fotomaske (13) die beiden dotierten Bereiche (2, 3) ersten Leitungstyps eindotiert;
12.2. Entfernen der Fotomaske (13);
12.3. Herstellen zweier Spacer (15, 16) an den Flanken (9, 10) der Control-Gate-Schicht (7);
12.4. Entfernen eines Spacers (15, 16) an einer der Flanken (9, 10) der Control-Gate-Schicht (7);
12.5. Entfernen des Dielektrikums (6) und der Floating-Gate-Schicht (5) von den Bereichen der ersten Hauptfläche (8), die nicht von der Control-Gate-Schicht (7) und nicht von dem verbleibenden Spacer (15, 16) überdeckt werden.
12.6. Entfernen des im Verfahrensschritt 12.4 nicht entfernten Spacers (15, 16).

13. Verfahren zur Herstellung einer Speicherzelle nach Anspruch 12, dadurch gekennzeichnet, daß Verfahrensschritt 12.4 entfällt und in Verfahrensschritt 12.6 beide Spacer (15, 16) entfernt werden.

14. Verfahren zur Herstellung einer Speicherzelle nach Anspruch 12 oder 13, dadurch gekennzeichnet, daß keine Deckschicht (14) auf der Control-Gate-Schicht (7) aufgebracht ist.
